# DEMANDE DE BREVET EUROPEEN

(11) **EP 4 817 838 A1**
(43) Date de publication de la demande: **07.10.2026**
(21) Numéro de dépôt: 26170284.9
(22) Date de dépôt: 01.04.2026
(51) Int. Cl.: B29B 17/02, H10F 19/80, B29L 31/34

(54) **PROCEDE DE SEPARATION CHIMIQUE DES MATERIAUX METALLIQUES ET DES POLYMERES DE PANNEAUX SOLAIRES PHOTOVOLTAÏQUES**

(30) Priorité: 03.04.2025 FR 2503519
(71) Demandeur: Commissariat à l'Energie Atomique et aux Energies Alternatives, 75015 Paris (FR)
(72) Inventeur: DUWALD, Romain, 38054 GRENOBLE (FR)
(74) Mandataire: Gevers & Orès

(57) **Abrégé**

L'invention concerne le domaine de la séparation physique et le recyclage des composants constitutifs d'un module photovoltaïque à base de silicium. En particulier, l'invention a pour but de séparer les polymères provenant de cellules solaires des métaux sans dégradation ni des polymères ni des métaux. La séparation n'entraine pas de dégradation des solvants qui pourront être réutilisés sans nécessiter de purification, abaissant l'impact carbone global du procédé.

La séparation repose sur une séparation physique des différents matériaux en utilisant leur densité.

## Description

### Domaine technique de l'invention

L'invention concerne le domaine de la séparation physique et le recyclage des composants constitutifs d'un module photovoltaïque à base de silicium. En particulier, l'invention a pour but de séparer les polymères provenant de cellules solaires des métaux sans dégradation ni des polymères ni des métaux. La séparation n'entraine pas de dégradation des solvants qui pourront être réutilisés sans nécessiter de purification, abaissant l'impact carbone global du procédé.

La séparation repose sur une séparation physique des différents matériaux en utilisant leur densité.

### Arrière-plan technique

Les énergies dites renouvelables se développent rapidement en tant que solution à la production d'une énergie décarbonée. Parmi ces énergies renouvelables, l'énergie solaire est produite via la conversion des rayonnements solaires en électricité par des panneaux photovoltaïques. Lorsqu'un panneau solaire arrive en fin de vie, il doit être démantelé pour être recyclé. Il convient donc de limiter autant que possible l'impact sur l'environnement, de la phase de fin de vie des panneaux photovoltaïques. Les panneaux solaires photovoltaïques au silicium cristallin sont constitués d'une superposition de couches comme montré en [**Erreur ! Source du renvoi introuvable.**]. Une plaque de verre en face avant permet de protéger les cellules des agressions extérieures (intempéries, poussière, etc). La face ou couche arrière est un assemblage polymère multicouche, intégrant généralement une feuille de polymère fluoré (le poly(fluorure de vinyle) ou PVF, le poly(fluorure de vinylidène) ou PVDF, etc.) et d'autres feuilles polymères telles que du polyéthylène (PE) ou du polyéthylène téréphtalate (PET). Les cellules solaires en silicium sont encapsulées dans un polymère réticulé. L'encapsulant majoritairement rencontré dans les panneaux est l'EVA ou le poly(éthylène-acétate de vinyle).

L'EVA est majoritairement utilisé puisqu'il permet de maintenir la bonne intégrité des panneaux dans le temps, leur offrant une grande résistance aux intempéries, à l'humidité et aux variations de températures.

Ce polymère est un thermoplastique, il peut donc être fondu pour être mis en forme lors de la fabrication d'un panneau. L'EVA est utilisé en films, formulés commercialement en intégrant des agents de réticulations, qui permettront de renforcer la structure du polymère lors de la mise en forme du panneau. Des agents d'adhésion sont également présents dans le polymère, il s'agit généralement d'organosilanes, permettant d'assurer une liaison chimique forte entre le verre et l'EVA et entre les cellules solaires et l'EVA. Un premier film d'encapsulant est placé entre la plaque de verre en face avant et les cellules solaires en silicium (c-Si), et un second film est placé derrière les cellules et avant la couche arrière ou backsheet en anglais. Lors de la fabrication de panneaux, les différentes couches sont pressées à chaud (laminage), permettant dans un même temps la fusion des films d'EVA pour encapsuler les cellules et lier les différentes couches, et l'activation des agents de réticulations et des agents d'adhésion par la chaleur. Les agents de réticulation permettent de transformer les chaines linéaires d'EVA en un réseau tridimensionnel dit « réticulé ». L'EVA linéaire thermoplastique fongible devient alors un EVA réticulé thermodur. La nature réticulée de l'encapsulant l'empêche d'être fondu et rend difficile la délamination des différentes couches des modules. L'EVA réticulé est considéré non recyclable. Les agents de liaisons organosilylés assurent la tenue de l'EVA au verre et aux cellules via la création de liaisons covalentes fortes, ce qui rend difficile la séparation des différents matériaux d'intérêt (verre, cellule silicium, cuivre, etc.).

Les métaux de la cellule sont les composants dont la valeur commerciale est la plus élevée. Pour atteindre ces métaux, les polymères sont généralement éliminés via une étape de pyrolyse, énergivore et potentiellement polluante (étape émettrice de CO₂) selon la nature des polymères présents dans le panneau (polymères fluorés notamment).

Plusieurs techniques ont été proposées pour recycler et séparer les composants des modules photovoltaïques à base de silicium.

La demande de brevet CN113976597 A décrit un procédé à faible consommation d'énergie permettant de séparer et de recycler tous les composants d'un module photovoltaïque. Dans ces travaux, les matériaux polymères et métalliques d'un panneau solaire sont séparés par voie chimique en utilisant un solvant organique. Les solvants rapportés dans la demande de brevet font usage de solvants halogénés tels que le trichloroéthane et le dichlorobenzène, particulièrement toxiques et environnementalement défavorables. De plus, le procédé décrit permet de séparer la couche arrière ou backsheet de l'ensemble encapsulant + cellules, mais ne permet pas de séparer les cellules de l'encapsulant (EVA). L'encapsulant est éliminé par un procédé de pyrolyse qui nuit au bilan environnemental du procédé.

J. Lee et al. (Waste Management vol. 190 (2024), pages 122-130), ont étudié la délamination chimique d'un panneau en utilisant différents solvants organiques : toluène, D-limonène et un solvant à eutectique profond (DES). Dans ces travaux, la couche arrière (ou backsheet) et le verre sont séparés facilement du reste du panneau (encapsulant + cellules). Le solvant organique est chauffé à 90 °C pour permettre un gonflement de l'encapsulant et une séparation partielle des cellules et de l'encapsulant (jusqu'à 95 % d'élimination de l'encapsulant sur des fractions tamisées à 1 mm dans le cas du D-limonène). Néanmoins, pour les fractions d'une taille supérieure à 1 mm, les fragments de cellules sont liés à l'encapsulant et à la couche arrière (ou backsheet) et ne peuvent pas être valorisées sans une étape de pyrolyse supplémentaire.

Dans S. He et al. (Separation and Purification Technology, vol. 359 (2025),130682*)*, les différents matériaux d'un panneau solaire sont séparés par voie chimique en utilisant de l'éthanol et du carbonate de sodium (Na₂CO₃) en phase aqueuse. La séparation est réalisée en deux étapes. Dans la première étape, un morceau de panneau d'une taille de 30 x 30 mm est placé dans un réacteur solvothermal. De l'éthanol anhydre est ajouté puis le réacteur est monté à une température de 200°C pour une durée allant de 5 à 75 minutes. Cette étape permet de séparer la couche arrière ou backsheet et l'électrode d'aluminium situé en face arrière de la cellule solaire. Dans un second temps, l'éthanol est remplacé par une solution aqueuse de carbonate de sodium à une concentration comprise entre 0,2 M et 0,5 M. Le réacteur est à nouveau monté à une température comprise entre 160 °C et 200 °C pour une durée comprise entre 60 et 120 minutes. Cette seconde étape permet de séparer l'encapsulant et les grilles d'argent de la cellule en silicium. Ces travaux permettent une bonne séparation des matériaux, mais ne sont aujourd'hui pas envisageable à grande échelle. De plus, le travail à haute température nécessite de fournir beaucoup d'énergie au système, et de travailler dans un réacteur capable de tenir une pression élevée.

Il existe donc un réel besoin de disposer d'un procédé de délamination permettant de séparer tous les composants constitutifs d'un module photovoltaïque à base de silicium, sans dégradation ni des polymères ni des métaux. De plus, les procédés de pyrolyse permettant d'éliminer les polymères sont généralement générateurs de composés fluorés nocifs pour l'environnement.

Etant donné les volumes de déchets à venir liés à la fin de vie des panneaux solaires, il existe un réel besoin de disposer d'un procédé de recyclage ayant un impact carbone global réduit en termes d'énergie et de pollution en particulier par émission de CO₂. La présente invention propose une méthode de délamination de panneaux solaires à cellule silicium sans dégradation des différents matériaux constitutifs des panneaux solaires photovoltaïques.

### Résumé de l'invention

La présente invention a précisément pour but de répondre à ce besoin, en fournissant un procédé de séparation de l'encapsulant et des cellules d'un panneau solaire photovoltaïque, caractérisé en ce qu'il comprend les étapes suivantes :
**a)** Disposer de débris solides d'un panneau solaire photovoltaïque comprenant des cellules en silicium, un encapsulant polymère et un panneau arrière polymère appelé également backsheet en anglais,
**b)** Ajouter un solvant organique non miscible à l'eau aux débris, le solvant étant choisi parmi
   - les alcools primaires de formule R₀-CH₂OH avec R₀ représentant groupe alkyle comportant 4 à 8 atomes de carbone,
   - les hydrocarbures aliphatiques de formule CₙH₍₂ₙ₊₂₎ avec 5 ≤ n ≤ 12,
   - les terpènes,
   - les cycloalkanones hétérocycliques,
   - les organophosphorés de formule RO₃PO avec R représentant un groupe alkyle comportant 3 à 8 atomes de carbone,
   - les hydrocarbures aromatiques,
   - les solvants organiques de densité d > 0,997 choisis parmi les solvants halogénés, aliphatiques et aromatiques, et leur mélange,
   le rapport solide/liquide étant entre 1/2 et 1/100, de préférence entre 1/4 et 1/10, par exemple 1/5 ;
**c)** Préparer une solution aqueuse basique ayant un pH compris entre 8 et 14, de préférence entre 12 et 14, et ajouter la solution aqueuse au mélange préparé en étape **b)**,
   le rapport solide/liquide étant entre 1/4 et 1/100, de préférence entre 1/4 et 1/40, par exemple 1/20 ;
**d)** Agiter le mélange obtenu à l'issue de l'étape **c)**, à une température comprise entre 20 et 100 °C, de préférence entre 40 et 80 °C, par exemple 60 °C ;
**e)** Séparer les différents éléments une fois l'encapsulant décollé des cellules, du verre et de la couche arrière ou backsheet en anglais.

Le procédé de l'invention permet la séparation des polymères provenant de cellules solaires des métaux, sans dégradation ni des polymères ni des métaux. De plus, cette séparation n'entraîne pas de dégradation des solvants qui pourront être réutilisés sans nécessiter de purification, réduisant ainsi l'impact carbone global du procédé.

La séparation chimique des matériaux de panneaux solaires en voie liquide peut être appliquée à différents entrants selon la méthode de délamination employée en amont (séparation de la plaque de verre du reste du panneau).

Un laminat issu d'une délamination par la méthode du couteau chauffant pourra être engagé dans le procédé de séparation des matériaux décrit dans l'invention pour isoler les métaux des cellules solaires, le polymère de l'encapsulant et les polymères du panneau arrière (backsheet en anglais). Un broyat de panneau contenant le verre, les cellules et les polymères pourra être engagé dans le procédé de séparation des matériaux décrit dans l'invention pour séparer le verre des métaux et des différents polymères.

Le procédé de l'invention se différentie des procédés décrits dans l'état de l'art par :
- La séparation des matériaux constitutifs d'un panneau solaire par voie chimique en utilisant un système biphasique formé par deux solvants non miscibles de densité différente.
- Il permet de séparer les différents éléments par décollement de l'encapsulant de la plaque de verre, de la cellule solaire en silicium et de la couche arrière (backsheet en anglais).
- Il permet dans le même temps de séparer par densité les différents éléments : les éléments lourds (verre, métaux) décantent en fond de réacteur lorsqu'ils sont décollés de l'encapsulant.
   L'encapsulant de densité d < 1 se trouve en surface de la phase liquide la moins dense. La couche arrière (backsheet) d'une densité d > 1 se trouve en dessous de la phase moins dense.

L'invention a également pour objet l'utilisation d'un procédé selon l'invention pour le recyclage des panneaux solaires photovoltaïques.

### Brève description des figures

D'autres caractéristiques et avantages de l'invention apparaitront au cours de la lecture de la description détaillée qui va suivre pour la compréhension de laquelle on se reportera aux dessins annexés dans lesquels :
[Fig.1] représente un schéma structural d'un panneau solaire photovoltaïque.
[Fig.2] représente la liste des éléments constitutifs d'un panneau solaire photovoltaïque (gauche), et une photo d'un laminat obtenu par délamination par la technique du couteau chauffant (droite).

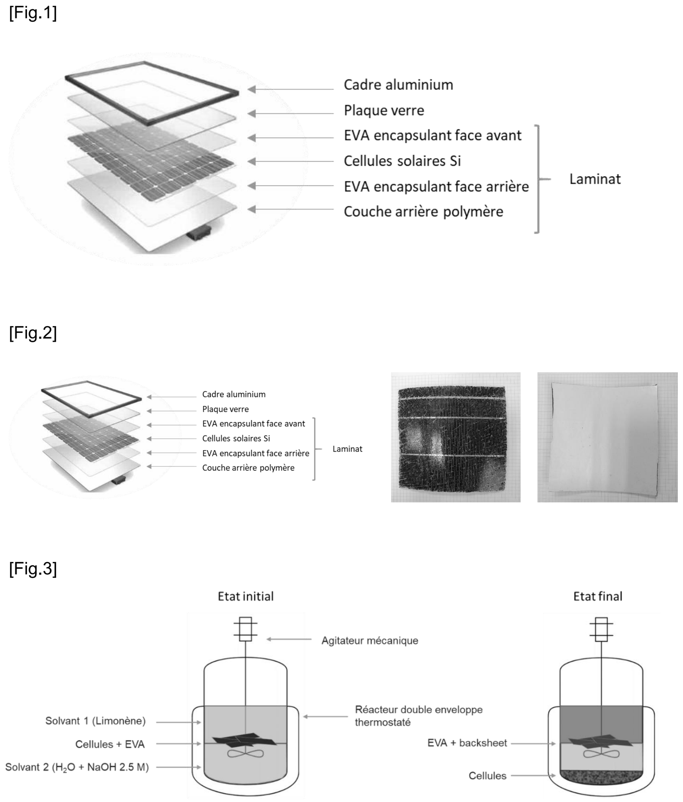

[Fig.3] (gauche) représente un réacteur double enveloppe au début de l'étape de séparation chimique des matériaux polymères et métalliques, contenant en haut une phase légère constituée d'un solvant non miscible à l'eau, en bas une phase lourde aqueuse à un pH compris entre 8 et 14 et à l'interphase, des débris provenant d'un laminat, provenant par d'une méthode de délamination par couteau chauffant, (droite) représente un réacteur double enveloppe à la fin de l'étape de séparation chimique des matériaux polymères et métalliques, contenant en haut une phase légère constituée d'un solvant non miscible à l'eau, en bas une phase lourde aqueuse à un pH compris entre 8 et 14, au fond du réacteur les matériaux métalliques provenant de cellules solaires en silicium et à l'interphase, les polymères.
[Fig.4] représente les matériaux récupérés en fin de l'étape procédé selon l'exemple 1 : gauche : films d'encapsulant EVA, milieu : poudre métallique de cellules, droite : feuillets de couche arrière ou backsheet polymère.
[Fig.5] représente le schéma du procédé de séparation des matériaux à partir d'un panneau solaire PV brisé selon l'exemple 2 :
   Gauche : état initial, réacteur double enveloppe contenant des débris d'un panneau solaire photovoltaïque brisé composé de verre, d'encapsulant polymère, de cellules solaires en silicium et d'une couche arrière en polymère (backsheet en anglais) et un solvant organique ;
   Milieu : après décollement du verre et de l'encapsulant, une seconde phase aqueuse, non miscible au solvant organique et à un pH compris entre 8 et 14 est additionné ;
   Droite : état final, les métaux provenant des cellules solaires en silicium se trouvent au fond du réacteur double enveloppe. La phase aqueuse à un pH compris entre 8 et 14 se trouve en bas et la phase organique légère se trouve en haut. A l'interphase se trouvent les polymères.

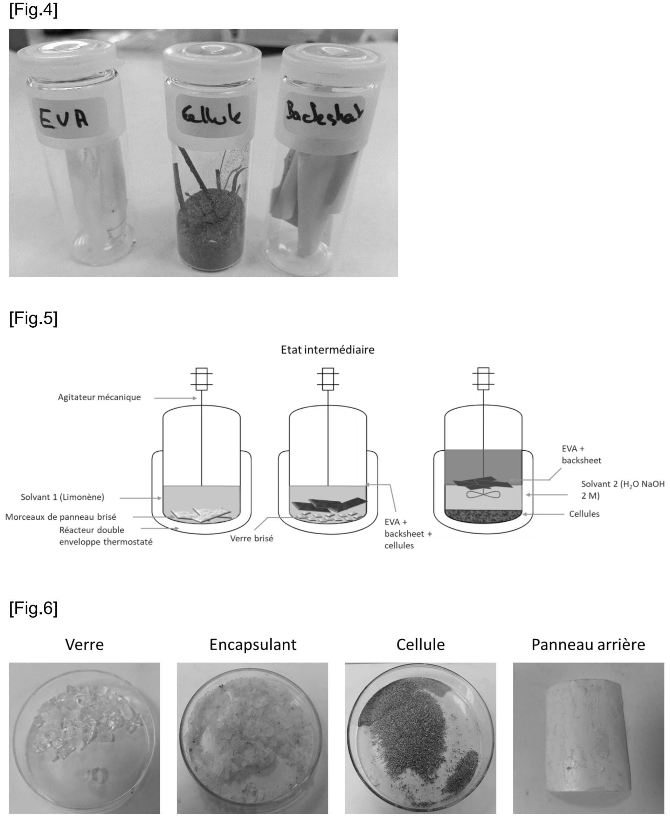

[Fig.6] représente les matériaux récupérés à la fin des différentes étapes de l'invention selon l'exemple 2. De gauche à droite : verre brisé, encapsulant EVA, fragments de cellules solaires, feuille de couche arrière ou backsheet.

### Description détaillée de l'invention

La présente invention concerne un procédé de séparation de l'encapsulant et des cellules d'un panneau solaire photovoltaïque, caractérisé en ce qu'il comprend les étapes suivantes :
**a)** Disposer de débris solides d'un panneau solaire photovoltaïque comprenant des cellules en silicium, un encapsulant polymère et un panneau arrière polymère appelé également backsheet en anglais,
**b)** Ajouter un solvant organique non miscible à l'eau aux débris, le solvant étant choisi parmi
   - les alcools primaires de formule R₀-CH₂OH avec R₀ représentant groupe alkyle comportant 4 à 8 atomes de carbone,
   - les hydrocarbures aliphatiques de formule CₙH₍₂ₙ₊₂₎ avec 5 ≤ n ≤ 12,
   - les terpènes,
   - les cycloalkanones hétérocycliques,
   - les organophosphorés de formule RO₃PO avec R représentant un groupe alkyle comportant 3 à 8 atomes de carbone,
   - les hydrocarbures aromatiques,
   - les solvants organiques de densité d > 0,997 choisis parmi les solvants halogénés aliphatiques et aromatiques,
      et leur mélange,
   le rapport solide/liquide étant entre 1/2 et 1/100, de préférence entre 1/4 et 1/10, par exemple 1/5 ;
**c)** Préparer une solution aqueuse basique ayant un pH compris entre 8 et 14, de préférence entre 12 et 14, et ajouter la solution aqueuse au mélange préparé en étape **b)**,
   le rapport solide/liquide étant entre 1/4 et 1/100, de préférence entre 1/4 et 1/40, par exemple 1/20;
**d)** Agiter le mélange obtenu à l'issue de l'étape c), à une température comprise entre 20 et 100 °C, de préférence entre 40 et 80°C, par exemple 60 °C ;
**e)** Séparer les différents éléments une fois l'encapsulant décollé des cellules, du verre et de la couche arrière ou backsheet en anglais.

Dans le contexte de l'invention, les termes « couche arrière » et « backsheet » en anglais, sont équivalents et parfaitement interchangeables. A l'étape **a)** les débris solides sont placés, par exemple, dans un réacteur à double enveloppe permettant de contrôler la température et équipé d'un système d'agitation. Les débris peuvent contenir du verre sans nuire à l'efficacité du procédé.

A l'étape **b)**, le solvant organique non miscible à l'eau est choisi parmi
- les alcools primaires choisis parmi le butanol, le pentanol, l'hexanol, l'heptanol, l'octanol, de préférence l'hexanol,
- les hydrocarbures aliphatiques choisis parmi le pentane, l'hexane, l'heptane, l'octane, le nonane, le décane, l'undécane et leurs isomères, de préférence l'heptane,
- les terpènes choisis parmi le D-limonène, le L-limonène ou leur mélange, l'*alpha*-terpinéol, l'α-pinène, le β-pinène, de préférence le D-limonène, le L-limonène ou leur mélange,
- les cycloalkanones hétérocycliques choisis parmi le cyrène, de préférence la cyclopentanone,
- les organophosphorés choisi parmi le tripropylphosphate, le tributylphosphate, le tripentyl phosphate, le trihexylphosphate, le triheptylphosphate, le trioctylphosphate, le tris(2-éthyl hexyl) phosphate, de préférence le tributylphosphate,
- les hydrocarbures aromatiques choisis parmi le benzène, le toluène, les différents isomères du xylène (ortho-, meta- et para-xylène), le p-cymène, de préférence le xylène (ortho-, meta- et para-xylène),
- les solvants halogénés choisis parmi le dichlorométhane, le chloroforme, le tétrachloroéthane, le chlorobenzène, les différents isomères du dichlorobenzène (ortho-, meta- et para-dichlorobenzène, les différents isomères du chlorotoluène (2-, 3- et 4-chlorotoluène), de préférence l'ortho-dichlorobenzène,
   et leur mélange.

Dans le cas où les morceaux de panneaux contiennent du verre, après addition du solvant organique, le mélange obtenu à l'étape **b)** est chauffé à une température comprise entre 20 et 110 °C, de préférence entre 40 et 80 °C, par exemple 60 °C. Cette étape de chauffage (étape **b-1**)) permet de décoller le verre de l'encapsulant avant de commencer à détacher l'encapsulant des cellules. Le verre pourra être séparé du reste des matériaux avant de passer à l'étape **c).**

La base utilisée dans la solution aqueuse de l'étape **c)** est choisie parmi
- les hydroxydes de métaux alcalins choisis parmi LiOH, NaOH, KOH,
- les carbonates de métaux alcalins et alcalinotérreux choisis parmi Na₂CO₃, K₂CO₃, CaCO₃, NaHCO₃, KHCO₃, CsCO₃, et
leur mélange.

Le pH est compris entre pH = 8 et pH = 14, de préférence entre 12 et 14.

La durée de l'agitation à l'étape **d)** est de 2 h à 24 h, de préférence de 8 h à 16 h, par exemple 12 h. L'agitation est à une vitesse comprise entre 30 et 1000 tr/min., par exemple à 180 tr/min.

En fin d'étape **d)** du procédé, l'agitation est arrêtée et la matière laissée à décanter. Les différents éléments sont alors séparés à l'étape **e).** Les métaux décantent au fond du réacteur. Une phase solide composée l'encapsulant polymère est en surface du réacteur. Les polymères de plus faible densité peuvent être séparés par tamisage, par flottation ou par débordement.

La composition d'un module photovoltaïque utilisé dans le procédé de l'invention est illustrée en [Fig.1].

Le cadre en aluminium sert à maintenir les différentes couches entre elles. Ce cadre est écarté avant toute étape de délamination.

Les verres utilisés sont soit des verres cristallins (mono ou polycrystallins), soit des verres à couches minces. Les verres sont parfois recouverts d'un revêtement afin de diminuer leur réflexion et à faible teneur en Fe, afin d'obtenir des valeurs de transparences élevées connues sous le nom de verre à faible teneur en fer ou verre ultra-blanc.

L'encapsulant en face avant et en face arrière des cellules solaires utilisé dans le procédé de l'invention est en poly(éthylène-acétate de vinyle) ou EVA.

La cellule photovoltaïque peut être à base de silicium, de séléniure de cuivreindium (CuIn(Se)₂, ou CIS), de séléniure de cuivre, indium et de gallium (CuInGa(Se)₂, aussi appelé CIGS), ou de tellure de cadmium (CdTe). De préférence, la cellule photovoltaïque est à base de silicium.

La couche arrière ou backsheet en anglais est une couche protectrice supportant le tout. Elle peut être en polyfluorure de vinylidène (PVDF), poly(oxyde de *p*-phénylène) (PPO) ou poly(éther de *p*-phénylène) (PPE), poly(téréphtalate d'éthylène) (PET), chlorure de polyvinyle (PVC), ou élastomère thermoplastique (TPE) ou en verre. De préférence, elle est en assemblage multicouche contenant au moins un polymère fluoré de type PVDF et un second polymère, par exemple le PET.

Lorsqu'un panneau solaire arrive en fin de vie, il doit être démantelé pour être recyclé. La première étape, mécanique, consiste à retirer le cadre en aluminium servant à maintenir les différentes couches entre elles. Pour un panneau solaire en fin de vie, la plaque de verre peut être soit intacte (la plaque de verre provenant d'un panneau avec une perte de rendement, d'une délamination partielle, etc.), soit brisée (intempéries, casse durant le transport de l'objet, etc.). On appelle délamination l'étape d'un procédé de recyclage permettant de séparer le verre du reste des matériaux d'un panneau. Il existe sur le marché plusieurs voies de délamination. La méthode de délamination d'un panneau en fin de vie sera essentiellement dépendante de l'état de la plaque de verre.
i) Dans le cas où le panneau de verre est intact, une des méthodes rencontrées dans le recyclage de panneau est la délamination par couteau chauffant. Dans cet exemple, une lame métallique chauffée à une température de 300 °C est passée entre la plaque de verre et la première couche d'encapsulant. La plaque de verre est séparée du reste du panneau sans dégât. Il en sort un laminat multicouches, composé du backsheet, et des cellules solaires encapsulées sur chaque face par l'encapsulant polymère en EVA.
ii) Lorsque la plaque de verre est brisée, il existe plusieurs méthodes de séparation du verre du reste du panneau. Une méthode est le raclage des morceaux de verre sur le panneau. Les morceaux de verres sont ainsi facilement séparés du reste du panneau. D'autres méthodes consistent à broyer le panneau avant d'envoyer le broyat dans des fours de pyrolyse pour éliminer les polymères. Ces procédés, bien qu'efficaces causent la production de gaz de combustion. Les polymères ne peuvent pas être recyclés puisqu'ils sont détruits, et les métaux peuvent former des alliages si la température de combustion des polymères est proche de la température de fusion de certains des métaux présents dans le milieu (plomb, étain, aluminium, argent, cuivre). Les matériaux sont ensuite séparés par tamisage, ce qui ne permet pas d'obtenir des grades de pureté élevés, notamment pour le verre. Enfin, certains travaux visant à réduire l'empreinte carbone des procédés proposent de séparer le verre des polymères en utilisant des solvants organiques. La stratégie repose sur le gonflement du polymère par absorption de solvant, entrainant le décollement entre le polymère et les matériaux durs tels que le verre et les cellules en silicium. Néanmoins, ces solvants sont généralement toxiques et polluants (solvants halogénés, hydrocarbures aromatiques, etc.), ou ne permettent pas de séparer intégralement l'encapsulant des cellules solaires.

Le principe de l'invention repose sur la séparation physique des différents matériaux, en utilisant des solvants. L'invention se différencie des voies de séparation chimique classiquement rencontrées puisqu'elle repose sur un mélange de solvants, constitué d'une phase organique et d'une phase aqueuse. Les deux phases ne sont pas miscibles, c'est-à-dire que l'association du solvant organique et de la phase aqueuse forme deux phases distinctes. La phase de densité la plus faible se trouvera au-dessus de la phase de densité la plus élevée. Pour l'eau pure, on considère une densité d = 0,997. Les solvants organiques de densité d < 0,997 constitueront la phase supérieure.

Par « eau pure », on entend une eau issue d'un traitement physique destiné à supprimer les impuretés. A ce titre, on peut citer l'eau distillée et l'eau déminéralisée (aussi appelée déionisée).

Le procédé de l'invention permet la séparation des différents matériaux à partir d'un mélange de solvants biphasique. La phase aqueuse contient une base, la phase organique permet de faire gonfler l'encapsulant. Les matériaux sont séparés par densité.

L'ajout du mélange de déchets provenant d'un panneau solaire (polymères + métaux ou polymères + métaux + verre) constituera une phase supplémentaire solide. La séparation des polymères et des métaux est garantie par leur différence de densité. Les métaux et polymères d'une densité d > 1 décanteront au fond du système multiphasique alors que les polymères de densité d < 1 monteront à la surface de la phase aqueuse.

Le procédé de l'invention permet de séparer les polymères provenant de cellules solaires des métaux sans dégradation ni des polymères ni des métaux. La séparation n'entraine pas de dégradation des solvants qui pourront être réutilisés sans nécessiter de purification, abaissant l'impact carbone global du procédé.

Les principaux métaux utilisés dans les panneaux solaires sont l'aluminium, l'acier, le cuivre, l'argent et le zinc. L'aluminium ou l'acier composent souvent les supports et le système de support. Parfois, l'aluminium fournit également le câblage. Le cuivre peut constituer le câblage du panneau solaire. L'invention a également pour objet l'utilisation d'un procédé selon l'invention pour le recyclage des panneaux solaires photovoltaïques.

### EXEMPLES

Le D,L-Limonène a été acheté chez Arcane Industries SA, l'hydroxyde de sodium (pureté 95-100 %) a été acheté chez Sigma Aldrich. Le laminat a été obtenu par délamination par couteau chauffant par la société Envie aquitaine à partir d'un panneau solaire photovoltaïque TRINA Solar en fin de vie. Le laminat a été découpé à l'aide d'une cisaille métallique en pièces de 10 x 10 cm.

### Exemple 1 : Séparation des matériaux provenant de la délamination d'un panneau par la technique de couteau chauffant

Lorsqu'un panneau est délaminé par la technique du couteau chauffant, technique bien connue de l'homme du métier, il en résulte un film souple composé d'un assemblage de couche arrière ou backsheet, de cellules solaires et de l'encapsulant EVA comme montré en [**Erreur** ! **Source du renvoi introuvable.**]-droite. Le procédé de l'invention permet de séparer les métaux des cellules des différents polymères par voie chimique en conditions douces.

Dans ce cas, le procédé de l'invention utilise un système à trois phases liquide/liquide/solide. Les deux phases liquides sont constituées d'une phase aqueuse lourde et d'une phase organique légère. La phase aqueuse est basique, dans l'exemple présenté ici, il s'agit d'une solution d'hydroxyde de sodium NaOH de concentration 2 M (d = 1,08). La phase organique légère ici utilisée est le DL-limonène (d = 0,84). Le laminat est découpé en fragments de 10 x 10 cm et placé dans un réacteur contenant le mélange de solvants. Le rapport solide/liquide est fixé à 1/20 en masse. Le système est agité par agitation mécanique à 180 tr/min., et chauffé à 80°C pendant 16 h. A la fin de la période de chauffe, l'agitation et le chauffage sont arrêtés. Les métaux décantent au fond du réacteur et les polymères se trouvent à l'interface entre les deux solvants. La séparation entre métaux et polymères peut alors être assuré par simple tamisage.

La [Fig.4] montre les matériaux récupérés en fin de l'étape de procédé.

### Exemple 2 : Séparation des matériaux provenant d'un panneau photovoltaïque brisé

Dans ce mode de réalisation, un panneau possède une plaque avant en verre brisé. La méthode de séparation des matériaux à partir d'un mélange multiphasique de solvants peut être utilisée pour le recyclage de panneaux brisés. Dans cet exemple, le verre peut être isolé du reste des matériaux pour être revalorisé. Cet exemple nécessite trois étapes successives :
i) séparation du verre par gonflement de l'encapsulant,
ii) séparation cellules/encapsulant/backsheet dans un milieu biphasique, et
iii) séparation des matériaux selon leur densité.

Première étape (étape i)) : La première étape du procédé permet de séparer le verre de l'encapsulant par gonflement de celui-ci. La première étape repose donc sur l'immersion du panneau dans un solvant organique capable de faire gonfler l'encapsulant.

Le panneau est découpé en fragments de 16 x 16 cm et placé dans un réacteur contenant un solvant organique. Dans ce mode de réalisation, le solvant choisi est le DL-limonène. Le morceau de panneau est immergé dans le solvant, avec un rapport solide/liquide de 1/10. Le solvant est chauffé à une température de 80 °C. L'agitation est fixée à 70 rpm. Le verre est rapidement détaché de l'ensemble encapsulant + cellules + backsheet. Le verre peut ensuite être extrait du solvant par filtration.

Deuxième étape (étape ii)) : A l'ensemble multicouche constitué d'encapsulant, de cellules solaires et du backsheet en suspension dans le DL-limonène est ajouté une solution aqueuse. Le système obtenu est un système à trois phases liquide/liquide/solide. Les deux phases liquides sont dans ce cas une phase inférieure aqueuse et une phase supérieure organique.

La phase aqueuse est basique, dans l'exemple présenté ici, il s'agit d'une solution d'hydroxyde de sodium NaOH de concentration comprise entre 0,1 M et 10 M, et avantageusement à une concentration de 2 M (d = 1,08). La phase organique légère ici utilisée est le DL-limonène (d = 0,84). Le rapport solide/liquide est fixé à 1/20 en masse. Le système est agité par agitation mécanique à 180 tr/min., et chauffé à 80°C pendant 16h. A la fin de la période de chauffe, l'agitation et le chauffage sont arrêtés.

Troisième étape (étape iii)) : Les métaux se trouvent au fond du réacteur et les polymères se trouvent à l'interface entre les deux solvants. La couche arrière ou backsheet a conservé sa taille initiale alors que l'encapsulant se trouve sous forme de petits fragments pouvant atteindre 2 cm. La séparation entre métaux et polymères peut alors être assuré par récupération manuelle des polymères à l'interface, ou par débordement. Les métaux sont séparés des solvants par filtration.

Ces étapes sont montrées en [Fig.5]. Les matériaux récupérés sont montrés en [Fig.6].

## Revendications

1. Procédé de séparation de l'encapsulant et des cellules d'un panneau solaire photovoltaïque, **caractérisé en ce qu'**il comprend les étapes suivantes :
**a)** Disposer de débris solides d'un panneau solaire photovoltaïque comprenant des cellules en silicium, un encapsulant polymère et un panneau arrière polymère appelé également backsheet en anglais,
**b)** Ajouter un solvant organique non miscible à l'eau aux débris, le solvant étant choisi parmi
- les alcools primaires de formule R₀-CH₂OH avec R₀ représentant groupe alkyle comportant 4 à 8 atomes de carbone,
- les hydrocarbures aliphatiques de formule CnH(2n+2) avec 5 ≤ n ≤ 12,
- les terpènes,
- les cycloalkanones hétérocycliques,
- les organophosphorés de formule RO₃PO avec R représentant un groupe alkyle comportant 3 à 8 atomes de carbone,
- les hydrocarbures aromatiques,
- les solvants organiques de densité d > 0,997 choisis parmi les solvants halogénés aliphatiques ou aromatiques,
et leur mélange,
le rapport solide/liquide étant entre 1/2 et 1/100, de préférence entre 1/4 et 1/10, par exemple 1/5 ;
**c)** Préparer une solution aqueuse basique ayant un pH compris entre 8 et 14, de préférence entre 12 et 14, et ajouter la solution aqueuse au mélange préparé en étape **b)**,
le rapport solide/liquide étant entre 1/4 et 1/100, de préférence entre 1/4 et 1/40, par exemple 1/20;
**d)** Agiter le mélange obtenu à l'issue de l'étape **c)** à une température comprise entre 20 et 100 °C, de préférence entre 40 et 80°C, par exemple 60 °C ;
**e)** Séparer les différents éléments une fois l'encapsulant décollé des cellules, du verre et de la couche arrière ou backsheet en anglais.

2. Procédé selon la revendication 1, **caractérisé en ce que** le solvant organique non miscible à l'eau est choisi parmi
- les alcools primaires choisis parmi le butanol, le pentanol, l'hexanol, l'heptanol, l'octanol, de préférence l'hexanol,
- les hydrocarbures aliphatiques choisis parmi le pentane, l'hexane, l'heptane, l'octane, le nonane, le décane, l'undécane et leurs isomères, de préférence l'heptane,
- les terpènes choisis parmi le D-limonène, le L-limonène ou leur mélange, l'alpha-terpinéol, l'α-pinène, le β-pinène, de préférence le D-limonène, le L-limonène ou leur mélange,
- les cycloalkanones hétérocycliques choisis parmi le cyrène, de préférence la cyclopentanone,
- les organophosphorés choisi parmi le tripropylphosphate, le tributylphosphate, le tripentyl phosphate, le trihexylphosphate, le triheptylphosphate, le trioctylphosphate, le tris(2-éthyl hexyl) phosphate, de préférence le tributylphosphate,
- les hydrocarbures aromatiques choisis parmi le benzène, le toluène, les différents isomères du xylène (ortho-, meta- et para-xylène), le p-cymène, de préférence le xylène (ortho-, meta- et para-xylène),
- les solvants halogénés choisis parmi le dichlorométhane, le chloroforme, le tétrachloroéthane, le chlorobenzène, les différents isomères du dichlorobenzène (ortho-, meta- et para-dichlorobenzène, les différents isomères du chlorotoluène (2-, 3- et 4-chlorotoluène), de préférence l'ortho-dichlorobenzène,
et leur mélange.

3. Procédé selon l'une des revendications 1 ou 2, **caractérisé en ce que** dans le cas où les morceaux de panneaux contiennent du verre, après addition du solvant organique, le mélange obtenu à l'étape **b)** est chauffé à une température comprise entre 20 et 100°C, de préférence entre 40 et 80°C (étape **b-1**)).

4. Procédé selon l'une quelconque des revendications 1 à 3, **caractérisé en ce que** la base utilisée dans la solution aqueuse de l'étape **c)** est choisie parmi
- les hydroxydes de métaux alcalins choisis parmi LiOH, NaOH, KOH,
- les carbonates de métaux alcalins et alcalinotérreux choisis parmi Na₂CO₃, K₂CO₃, CaCO₃, NaHCO₃, KHCO₃, CsCO₃, et
leur mélange.

5. Procédé selon l'une quelconque des revendications 1 à 4, **caractérisé en ce que** le pH est compris entre 8 et 14 et de préférence entre 12 et 14.

6. Procédé selon l'une quelconque des revendications 1 à 5, **caractérisé en ce que** la durée de l'agitation à l'étape **d)** est de 2 h à 24 h, de préférence de 8 h à 16 h.

7. Utilisation d'un procédé selon l'une quelconque des revendications 1 à 6, pour le recyclage des panneaux solaires photovoltaïques.
